# EUROPEAN PATENT APPLICATION

(11) **EP 4 611 266 A1**
(43) Date of publication of application: **03.09.2025**
(21) Application number: 25158764.8
(22) Date of filing: 19.02.2025
(51) Int. Cl.: H03M 13/17, H03M 13/19, H03M 13/00

(54) **INTEGRATED CIRCUIT AND MEMORY SYSTEM INCLUDING ECC CIRCUIT**

(30) Priority: 29.02.2024 KR 20240029555; 19.04.2024 KR 20240052853
(71) Applicant: SK hynix Inc., Bubal-eub Icheon-si Gyeonggi-do 17336 (KR)
(72) Inventor: HAN, Dong Hee, 17336 Icheon-si, Gyeonggi-do (KR); KANG, Seong Yoon, 17336 Icheon-si, Gyeonggi-do (KR); JANG, Mun Seon, 17336 Icheon-si, Gyeonggi-do (KR); CHA, Sang Uhn, 17336 Icheon-si, Gyeonggi-do (KR)
(74) Representative: Isarpatent

(57) **Abstract**

An integrated circuit includes an ECC encoder circuit configured to operate an H matrix on transmission data, to generate a transmission parity to be transmitted together with the transmission data, the transmission parity corresponding to the transmission data; and an ECC decoder circuit configured to operate the H matrix on reception data and a reception parity to detect and correct an error in the reception data. A data portion of the H matrix is divided into N groups, and each of the N groups includes a group matrix portion for distinguishing groups and a non-group matrix portion for distinguishing bits within a corresponding group. The group matrix portion is used by k group matrices that circulate in the N groups, and each time the k group matrices circulate one round, positions of the k group matrices inserted in groups are shifted.

## Description

### CROSS-REFERENCE TO RELATED APPLICATION

This application claims priority under 35 U.S.C. §119(a) to Korean Patent Applications No. 10-2024-0029555 filed on February 29, 2024 and No. 10-2024-0052853 filed on April 19, 2024, which are incorporated herein by reference in their entirety.

### BACKGROUND

### 1. Technical Field

Embodiments of the present disclosure relate to an integrated circuit and a memory system.

### 2. Related Art

In the early days of a semiconductor memory industry, a plurality of original good dies having no defective memory cells in a memory chip having passed through a semiconductor manufacturing process have been distributed on a wafer. However, as the capacity of a memory device gradually increases, it has become difficult to produce a memory device having no defective memory cells. At the present time, there is no probability that such a memory device will be manufactured. As one way to overcome such a situation, a method of repairing defective memory cells of a memory device with redundancy memory cells is used.

As another way, an error, which occurs in a memory cell and an error, which occurs when data is transmitted during a read and write process of a memory system, are corrected using an error correction circuit (i.e., ECC engine) that corrects an error in the memory system.

### SUMMARY

In an embodiment of the present disclosure, an integrated circuit includes an ECC encoder circuit configured to operate an H matrix on transmission data, to generate a transmission parity to be transmitted together with the transmission data, the transmission parity corresponding to the transmission data; and an ECC decoder circuit configured to operate the H matrix on reception data and a reception parity to detect and correct an error in the reception data, wherein a data portion of the H matrix is divided into N groups, each of the N groups comprises a group matrix portion for distinguishing groups and a non-group matrix portion for distinguishing bits within a corresponding group, the group matrix portion is used by k group matrices that circulate in the N groups, and each time the k group matrices circulate one round, positions of the k group matrices inserted in groups are shifted, where k is an integer equal to or more than 2 and N is an integer greater than k.

In an embodiment of the present disclosure, a memory system includes a memory controller and a memory, wherein the memory controller includes a first ECC encoder circuit configured to operate an H matrix on write data to generate a write parity corresponding to the write data; a first data transmission circuit configured to transmit the write data and the write parity to the memory; a first data reception circuit configured to receive read data and a read parity transmitted from the memory; and a first ECC decoder circuit configured to operate the H matrix on the read data and the read parity to detect and correct an error in the read data, wherein a data portion of the H matrix is divided into N groups, each of the N groups comprises a group matrix portion for distinguishing groups and a non-group matrix portion for distinguishing bits within a corresponding group, the group matrix portion is used by k group matrices that circulate in the N groups, and each time the k group matrices circulate one round, positions of the k group matrices inserted in groups are shifted, where k is an integer equal to or more than 2 and N is an integer greater than k.

In an embodiment of the present disclosure, a memory system includes a memory controller and a memory, wherein the memory controller includes a first ECC encoder circuit configured to operate an H matrix on 272-bit write data to generate a 16-bit write parity; a first data transmission circuit configured to transmit the write data and the write parity to the memory; a first data reception circuit configured to receive 272-bit read data and a 16-bit read parity transmitted from the memory; and a first ECC decoder circuit configured to operate the H matrix on the read data and the read parity into the H matrix to detect and correct an error in the read data, wherein the H matrix has a size of 16 × 288, a data portion of the H matrix is divided into 22 groups each having a size of 16 ×12 and one group having a size of 16 × 8, each of the 22 groups and the one group comprises a group matrix portion for distinguishing groups and a non-group matrix portion for distinguishing bits within a corresponding group, the group matrix portion is used by k group matrices that circulate in the 22 groups and the one group, and each time the k group matrices circulate one round, positions of the k group matrices inserted in groups is shifted, where k is an integer equal to or more than 2 and smaller than 23.

In an embodiment of the present disclosure, a memory system includes a memory core; and an ECC encoder circuit configured to operate an H matrix on write data to be stored in the memory core to generate a write parity code to be stored in the memory core together with the write data, the write parity code corresponding to the write data, wherein a data portion of the H matrix is divided into N groups, each of the N groups comprises a group matrix portion for distinguishing groups and a non-group matrix portion for distinguishing bits within a corresponding group, the group matrix portion is used by k group matrices that circulate in the N groups, and each time the k group matrices circulate one round, positions of the k group matrices inserted in groups are shifted, where k is an integer equal to or more than 2 and N is an integer greater than k.

In an embodiment of the present disclosure, an integrated circuit includes an ECC encoder circuit configured to operate an H matrix on data to generate a parity code corresponding to the data, wherein the H matrix comprises N groups each comprising a plurality of column vectors, each of the column vectors of each of the N groups comprises group index bits with a same value within a same group and non-group index bits with different values within the same group, the group index bits are used by k group index bits that circulate in the N groups, and each time the k group index bits circulate one cycle, positions of the group index bits inserted in column vectors are shifted, where k is an integer equal to or more than 2 and N is an integer greater than k.

### BRIEF DESCRIPTION OF THE DRAWINGS

FIG. 1 is a diagram illustrating a configuration of a memory system in accordance with an embodiment of the present disclosure.
FIG. 2 is a diagram illustrating a configuration of a memory system in accordance with another embodiment of the present disclosure.
FIG. 3 is a diagram illustrating a configuration of a memory system in accordance with another embodiment of the present disclosure.
FIG. 4 a diagram for describing an H matrix used by ECC circuits in FIGS. 1 to 3 in accordance with an embodiment of the present disclosure.
FIG. 5 is a diagram for describing a process in which each of the ECC encoder circuits in FIGS. 1 to 3 generates a parity code PAR by using the H matrix in FIG. 4 in accordance with an embodiment of the present disclosure.
FIG. 6 is a diagram for describing how parity codes are generated by each of the ECC encoder circuits in FIGS. 1 to 3 when data all have a value of 1 in accordance with an embodiment of the present disclosure.
FIG. 7 is a diagram for describing a process in which each of the ECC decoder circuits in FIGS. 1 to 3 generates syndromes by using the H matrix in FIG. 4 in accordance with an embodiment of the present disclosure.
FIG. 8 is a diagram for describing how the syndromes are generated by each of the ECC decoder circuits and how a 1-bit error is corrected when the 1-bit error exists in data input to the ECC decoder circuits in FIGS. 1 to 3 in accordance with an embodiment of the present disclosure.
FIGS. 9 and 10 are diagrams for describing how the syndromes are generated by each of the ECC decoder circuits and how a 2-bit error is processed when the 2-bit error exists in the data input to the ECC decoder circuits in FIGS. 1 to 3 in accordance with an embodiment of the present disclosure.
FIG. 11 is a diagram illustrating a configuration of an H matrix for preventing miscorrection and correctly detecting an error in accordance with an embodiment of the present disclosure.
FIGS. 12A to 12D are diagrams for describing an H matrix that complies with rules proposed in embodiments of the present disclosure.
FIGS. 13A to 13D are diagrams for describing another H matrix that complies with rules proposed in embodiments of the present disclosure.

### DETAILED DESCRIPTION

Various embodiments of the present disclosure are directed to a technology of sensing a multi-bit error occurring in a memory.

In accordance with embodiments of the present disclosure, a multi-bit error occurring in a memory system can be detected.

Hereafter, embodiments in accordance with the technical spirit of the present disclosure will be described with reference to the accompanying drawings.

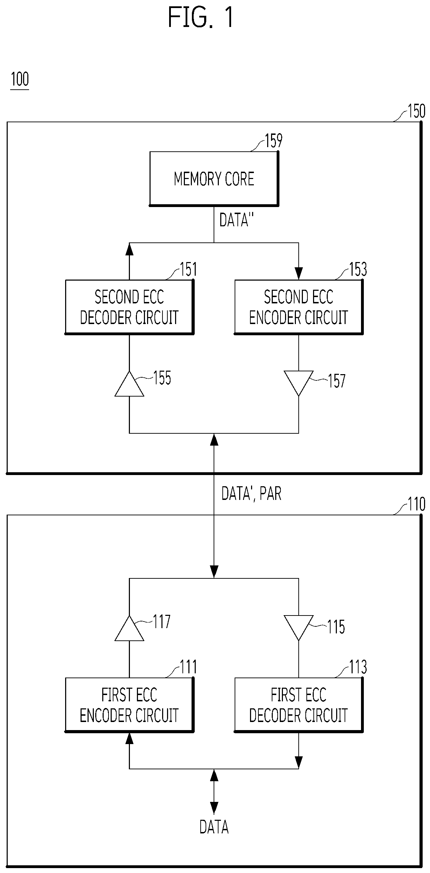

FIG. 1 is a diagram illustrating a configuration of a memory system 100 in accordance with an embodiment of the present disclosure. FIG. 1 illustrates only parts directly related to data transmission and error correction in the memory system 100.

Referring to FIG. 1, the memory system 100 may include a memory controller 110 and a memory 150.

In an embodiment, the memory controller 110 may control operations such as read and write of the memory 150 according to requests from a host. The memory controller 110 may include a first ECC encoder circuit 111, a first ECC decoder circuit 113, a first data reception circuit 115, and a first data transmission circuit 117.

In an embodiment, the first ECC encoder circuit 111 may generate a parity code PAR by using data DATA, that is, write data to be transmitted by the memory controller 110 to the memory 150. That is, in an embodiment, the first ECC encoder circuit 111 may encode the data DATA and generate the parity code PAR for correcting an error in the data DATA. Because only the parity code PAR is generated and no error correction operation is performed during the encoding operation, the data DATA input to the first ECC encoder circuit 111 and data DATA' output from the first ECC encoder circuit 111 are the same during the encoding operation.

In an embodiment, the first data transmission circuit 117 may transmit the data DATA' and the parity code PAR generated in the first ECC encoder circuit 111 to the memory 150. Because the data DATA' and the parity code PAR are transmitted from the memory controller 110 to the memory 150 during a write operation, the first data transmission circuit 117 is used during the write operation.

In an embodiment, the first data reception circuit 115 may receive data DATA' and a parity code PAR transmitted from the memory 150. Because the data DATA' and the parity code PAR are transmitted from the memory 150 to the memory controller 110 during a read operation, the first data reception circuit 115 is used during the read operation.

In an embodiment, the first ECC decoder circuit 111 may use the parity code PAR received by the first data reception circuit 115 to detect and correct an error in the data DATA' received by the first data reception circuit 115, that is, read data.

The memory 150 may include a second ECC decoder circuit 151, a second ECC encoder circuit 153, a second data reception circuit 155, a second data transmission circuit 157, and a memory core 159.

In an embodiment, the second data reception circuit 155 may receive the data DATA' and the parity code PAR transmitted from the memory controller 110. Because the data DATA' and the parity code PAR are transmitted from the memory controller 110 to the memory 150 during a write operation, the second data reception circuit 155 is used during the write operation.

In an embodiment, the second ECC decoder circuit 151 may use the parity code PAR received by the second data reception circuit 155 to detect and correct an error in the data DATA' received by the second data reception circuit 155, that is, write data. In an embodiment, data DATA" processed by the second ECC decoder circuit 151 is stored in the memory core 159.

In an embodiment, during a write operation, the memory core 159 may receive and store the data DATA" processed by the second ECC decoder circuit 151. In an embodiment, during a read operation, the memory core 159 may transfer the stored data DATA" to the second ECC encoder circuit 153. The memory core 159 may refer to a place in the memory 150 where data is stored, and include, for example, a plurality of memory cells for storing data and circuits for writing data to the plurality of memory cells and reading the data from the plurality of memory cells.

In an embodiment, the second ECC encoder circuit 153 may generate a parity code PAR by using the data DATA" transmitted from the memory core 159, that is, read data. That is, the second ECC encoder circuit 153 may encode the data DATA" and generate the parity code PAR for correcting an error in the data DATA". During the encoding operation, because only the parity code PAR is generated and no error correction operation is performed, the data DATA" input to the second ECC encoder circuit 153 and the data DATA' output from the second ECC encoder circuit 153 are the same during the encoding operation.

In an embodiment, the second data transmission circuit 157 may transmit the data DATA' and the parity code PAR generated by the second ECC encoder circuit 153 to the memory controller 110. Because the data DATA' and the parity code PAR are transmitted from the memory 150 to the memory controller 110 during a read operation, the second data transmission circuit 157 is used during the read operation.

Hereinafter, how a data error is handled during write and read operations of the memory system 100 is described.

In an embodiment, during a write operation, the first ECC encoder circuit 111 of the memory controller 110 may generate a parity code PAR for correcting an error in write data (DATA = DATA'), and the write data DATA' and the parity code PAR are transmitted from the memory controller 110 to the memory 150. The second ECC decoder circuit 151 of the memory 150 may detect and correct the error in the write data DATA' by using the parity code PAR, and data DATA" processed by the second ECC decoder circuit 151 is written to the memory core 159. That is, during the write operation, an error in the write data DATA', which occurs in the process of transmitting the write data DATA' from the memory controller 110 to the memory 150, can be detected and corrected by the operations of the first ECC encoder circuit 111 and the second ECC decoder circuit 151.

In an embodiment, during a read operation, the second ECC encoder circuit 153 of the memory 150 may generate a parity code PAR for correcting an error in the data DATA" (= DATA') read from the memory core 159, and the read data DATA' and the parity code PAR are transmitted from the memory 150 to the memory controller 110. In an embodiment, the first ECC decoder circuit 113 of the memory controller 110 may detect and correct an error in the data DATA' by using the parity code PAR, and the memory controller 110 may use the data DATA processed by the first ECC decoder circuit 113. That is, during the read operation, an error in the read data DATA', which occurs in the process of transmitting the read data DATA' from the memory 150 to the memory controller 110, can be detected and corrected by the operations of the second ECC encoder circuit 153 and the first ECC decoder circuit 113.

The error in the data DATA' transmitted and received between the memory controller 110 and the memory 150 can be detected and corrected by the ECC circuits 111 and 113 of the memory controller 110 and the ECC circuits 151 and 153 of the memory 150. In this way, the ECC circuits for sensing and correcting an error in data transmitted and received between two integrated circuits are also referred to as link ECC circuits. Although FIG. 1 illustrates an example in which the ECC circuits 111, 113, 151, and 153 are applied to the memory controller 110 and the memory 150, such circuits are also applicable to any two integrated circuits that exchange data (signals) with each other.

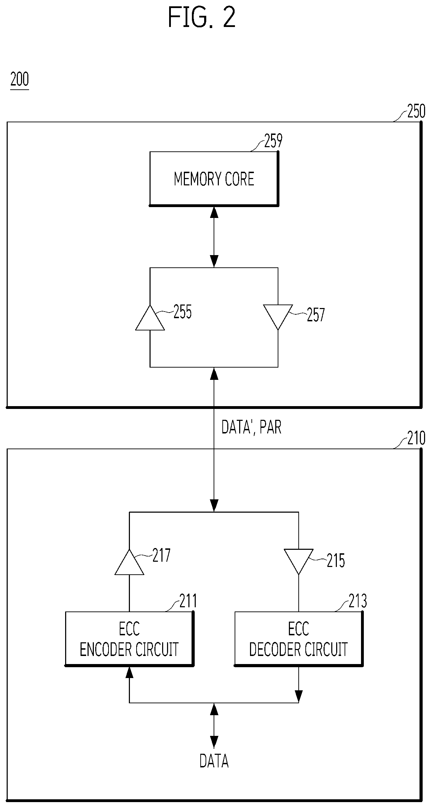

FIG. 2 is a diagram illustrating a configuration of a memory system 200 in accordance with another embodiment of the present invention. FIG. 2 illustrates only parts directly related to data transmission and error correction in the memory system 200.

Referring to FIG. 2, the memory system 200 may include a memory controller 210 and a memory 250. The memory controller 210 may include an ECC encoder circuit 211, an ECC decoder circuit 213, a first data reception circuit 215, and a first data transmission circuit 217. The memory 250 may include a second data reception circuit 255, a second data transmission circuit 257, and a memory core 259.

In an embodiment, the ECC encoder circuit 211 of the memory controller 210 may generate a parity code PAR by using data DATA (write data) to be transmitted by the memory controller 210 to the memory 250. That is, the ECC encoder circuit 211 may encode the data DATA and generate the parity code PAR for correcting an error in the data DATA. Because only the parity code PAR is generated and no error correction operation is performed during the encoding operation, the data DATA input to the ECC encoder circuit 211 and data DATA' output from the ECC encoder circuit 211 are the same during the encoding operation.

In an embodiment, the first data transmission circuit 217 of the memory controller 210 may transmit the data DATA' and the parity code PAR to the memory 250. Because the data DATA' and the parity code PAR are transmitted from the memory controller 210 to the memory 250 during a write operation, the first data transmission circuit 217 is used during the write operation.

In an embodiment, the second data reception circuit 255 of the memory 250 may receive the data DATA' and the parity code PAR transmitted from the memory controller 210, and the data DATA' and the parity code PAR received by the second data reception circuit 255 are stored in the memory core 259. That is, in the embodiment of FIG. 2, the parity code PAR is stored in the memory core 259 together with the data DATA' during the write operation.

In an embodiment, during a read operation, the data DATA' and the parity code PAR read from the memory core 259 are transmitted to the memory controller 210 through the second data transmission circuit 257.

In an embodiment, during the read operation, the first data reception circuit 215 of the memory controller 210 may receive the data DATA' and the parity code PAR transmitted from the memory 250, and the ECC decoder circuit 213 of the memory controller 210 can detect and correct an error in the data DATA' by using the parity code PAR.

In the memory system 200 of FIG. 2, the parity code PAR is generated in the ECC encoder circuit 211 of the memory controller 210 during a write operation, and is stored in the memory core 259 of the memory 250 together with the write data DATA'. During a read operation, the ECC decoder circuit 213 of the memory controller 210 can detect and correct an error in the data DATA' read from the memory core 259 by using the parity code PAR read from the memory core 259.

That is, in the memory system 200 of FIG. 2, in relation to error correction, the memory controller 210 may perform an encoding operation of generating the parity code PAR during a write operation, and may perform a decoding operation of detecting and correcting an error in the data DATA' by using the parity code PAR during a read operation.

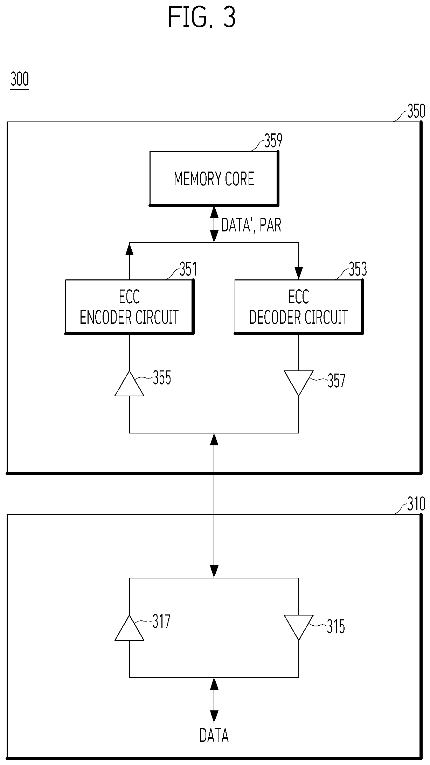

FIG. 3 is a diagram illustrating a configuration of a memory system 300 in accordance with another embodiment of the present invention. FIG. 3 illustrates only parts directly related to data transmission and error correction in the memory system 300.

Referring to FIG. 3, the memory system 300 may include a memory controller 310 and a memory 350.

The memory controller 310 may include a first data reception circuit 315 and a first data transmission circuit 317. The memory 350 may include an ECC encoder circuit 351, an ECC decoder circuit 353, a second data reception circuit 355, a second data transmission circuit 357, and a memory core 359.

In an embodiment, during a write operation, the first data transmission circuit 317 of the memory controller 310 may transmit write data DATA to the memory 350. The second data reception circuit 355 of the memory 350 may receive the write data DATA, and the ECC encoder circuit 351 of the memory 350 may generate a parity code PAR by using the write data DATA. The write data DATA' (DATA'=DATA during a write operation) and the parity code PAR are written to the memory core 359.

In an embodiment, during a read operation, the read data DATA' and the parity code PAR read from the memory core 359 are transmitted to the ECC decoder circuit 353, and the ECC decoder circuit 353 may detect and correct an error in the read data DATA' by using the parity code PAR. Subsequently, the read data DATA processed by the ECC decoder circuit 353 is transmitted to the memory controller 310 by the second data transmission circuit 357, and the first data reception circuit 315 of the memory controller 310 may receive the read data DATA.

That is, in the memory system 300 of FIG. 3, in relation to error correction, the memory 350 may perform an encoding operation of generating the parity code PAR during a write operation, and may perform a decoding operation of detecting and correcting an error in the data DATA' by using the parity code PAR during a read operation.

FIG. 2 illustrates an embodiment in which the ECC encoding circuit 211 and the ECC decoding circuit 213 are included in the memory controller 210, and FIG. 3 illustrates an embodiment in which the ECC encoding circuit 351 and the ECC decoding circuit 353 are included in the memory 350. In another embodiment, the ECC encoding circuit and the ECC decoding circuit are located at different points on a path where data is transmitted between the memory controller and the memory. For example, the ECC encoding circuit and the ECC decoding circuit may also be provided inside a buffer chip that buffers data transmitted between the memory controller and the memory.

The ECC circuits 111, 113, 151, 153, 211, 213, 351, and 353 of FIGS. 1 to 3 may perform encoding and decoding operations by using an H matrix also referred to as a check matrix, which is described below.

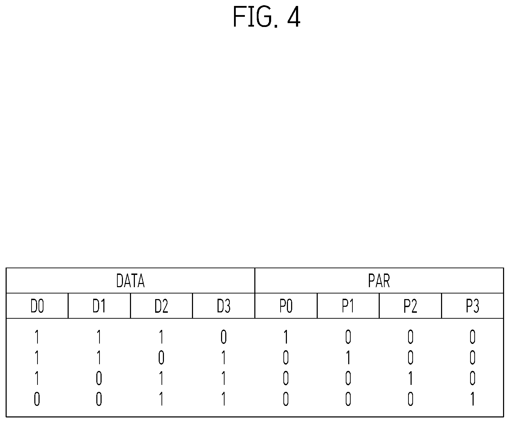

FIG. 4 illustrates an example of an H matrix used by the ECC circuits 111, 113, 151, 153, 211, 213, 351, and 353 of FIGS. 1 to 3. For convenience of description, the data DATA is 4 bits D0 to D3 and a parity code PAR is 4 bits P0 to P3. In an embodiment, the data DATA refers to data input to the ECC circuits 111, 113, 151, 153, 211, 213, 351, and 353.

In an embodiment, the H matrix is configured by a matrix of (number of bits of parity code) × (number of bits of data + number of bits of parity code). Because the parity code PAR is 4 bits and the data DATA is 4 bits, the H matrix is configured by a 4 × 8 matrix. Each component of the H matrix has a value of 1 or 0.

In an embodiment, column vectors of the H matrix correspond to the bits D0 to D3 of the data DATA and the bits P0 to P3 of the parity code PAR. For example, among eight column vectors, four column vectors correspond to the bits D0 to D3 of the data DATA, and four column vectors correspond to the bits P0 to P3 of the parity code PAR. In FIG. 4, it can be seen that D1 corresponds to a column vector with a value of '1110', and P3 corresponds to a column vector with a value of '0001'.

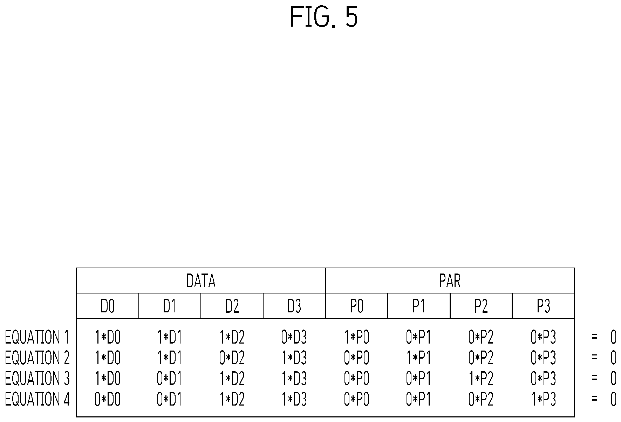

FIG. 5 is a diagram for describing a process in which each of the ECC encoder circuits 111, 153, 211, and 351 in FIGS. 1 to 3 generates the parity code PAR by using the H matrix in FIG. 4 in accordance with an embodiment of the present disclosure.

In an embodiment, each of the ECC encoder circuits 111, 153, 211, and 351 may multiply each of the column vectors of the H matrix with a corresponding bit and then generate the parity code PAR so that the sum of rows is 0 (that is, an even number).

That is, the parity code PAR is generated so that all four equations below are satisfied. 1*D0 + 1*D1 + 1*D2 + 0*D3 + 1*P0 + 0*P1 + 0*P2 + 0*P3 = 0 1*D0 + 1*D1 + 0*D2 + 1*D3 + 0*P0 + 1*P1 + 0*P2 + 0*P3 = 0 1*D0 + 0*D1 + 1*D2 + 1*D3 + 0*P0 + 0*P1 + 1*P2 + 0*P3 = 0 0*D0 + 0*D1 + 1*D2 + 1*D3 + 0*P0 + 0*P1 + 0*P2 + 1*P3 = 0

An addition in the above equations and the following description means an exclusive OR. Accordingly, the result of the addition is performed in such a way that when the number of 1's is even, the result is 0, and when the number of 1's is odd, the result is 1. For example, 1 + 1+0+1 is 1 and 0+1+1+0 is 0.

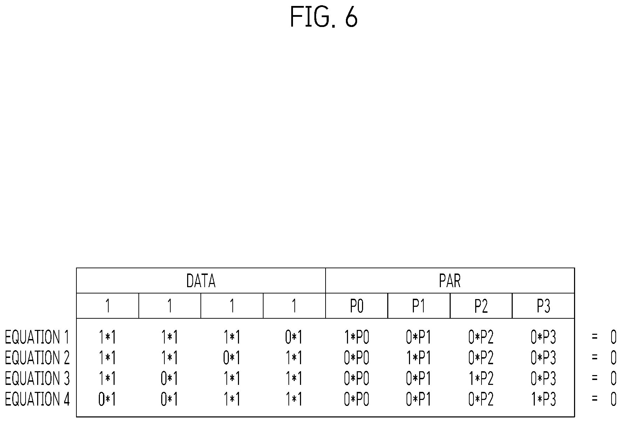

FIG. 6 is a diagram for describing how the parity codes P0 to P3 are generated by each of the ECC encoder circuits 111, 153, 211, and 351 in FIGS. 1 to 3 when the data D0 to D3 all have a value of 1 in accordance with an embodiment of the present disclosure.

Referring to FIG. 6, values of the error correction codes P0 to P3 are obtained by putting the value of 1 into the data D0 to D3 of Equation 1 to Equation 4 above and solving these Equations.

In this case, the error correction codes P0 to P3 are generated as (1, 1, 1, 0).

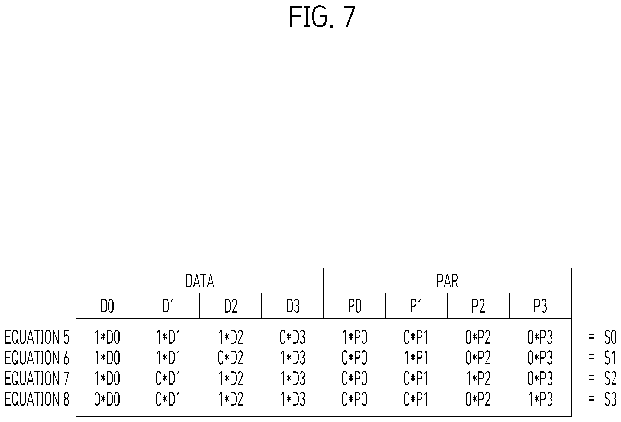

FIG. 7 is a diagram for describing a process in which each of the ECC decoder circuits 113, 151, 213, and 353 in FIGS. 1 to 3 generate syndromes S0 to S3 by using the H matrix in FIG. 4 in accordance with an embodiment of the present disclosure.

In an embodiment, each of the ECC decoder circuits 113, 151, 213, and 353 may generate the syndromes S0 to S3 by putting the data DATA and the parity code PAR input to them into the H matrix and operating the H matrix. Each of the ECC decoder circuits 113, 151, 213, and 353 may generate the syndromes S0 to S3 by multiplying each of the column vectors of the H matrix with a corresponding bit and then calculating the sum of rows.

That is, the syndromes S0 to S3 are generated using the following four Equations. The syndromes S0 to S3 are used to detect and correct an error. 1*D0 + 1*D1 + 1*D2 + 0*D3 + 1*P0 + 0*P1 + 0*P2 + 0*P3 = S0 1*D0 + 1*D1 + 0*D2 + 1*D3 + 0*P0 + 1*P1 + 0*P2 + 0*P3 = S1 1*D0 + 0*D1 + 1*D2 + 1*D3 + 0*P0 + 0*P1 + 1*P2 + 0*P3 = S2 0*D0 + 0*D1 + 1*D2 + 1*D3 + 0*P0 + 0*P1 + 0*P2 + 1*P3 = S3

When there is no error in the data DATA and the parity code PAR input to each of the ECC decoder circuits 113, 151, 213, and 353, the syndromes S0 to S3 generated by each of the ECC decoder circuits 113, 151, 213, and 353 all have a value of 0.

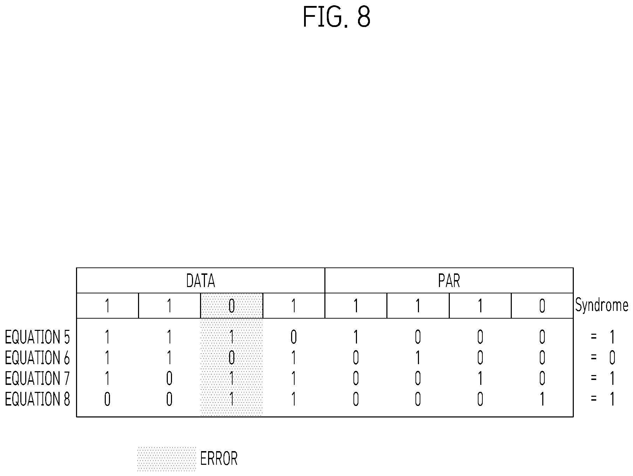

FIG. 8 is a diagram for describing how the syndromes S0 to S3 are generated by each of the ECC decoder circuits 113, 151, 213, and 353 and how a 1-bit error is corrected when the 1-bit error exists in data DATA input to the ECC decoder circuits 113, 151, 213, and 353 in FIGS. 1 to 3 in accordance with an embodiment of the present disclosure. In FIG. 8, an error has occurred after the data D0 to D3 all having a value of 1 as in the example of FIG. 6 are generated and the parity code PAR of (1, 1, 1, 0) is generated using the data D0 to D3.

Referring to FIG. 8, it can be seen that an error exists in which 1 bit D2 of the data DATA is changed from 1 to 0. When the data D0 to D3 and the parity codes P0 to P3 are put into Equation 5 to Equation 8 above and calculated, the syndromes S0 to S3 are generated as (1, 0, 1, 1).

When the values of the syndromes S0 to S3 are not (0, 0, 0, 0), it means that an error exists, and the values of the syndromes S0 to S3 indicate a bit where the error exists. That is, it indicates that an error exists in a bit corresponding to a column vector equal to the values of the syndromes S0 to S3. Because the values of the syndromes S0 to S3 are (1, 0, 1, 1), it indicates that an error exists in the bit D2 of the data DATA whose column vector value is (1, 0, 1, 1). In this case, the ECC decoder circuits 113, 151, 213, and 353 may correct the error by inverting the bit D2.

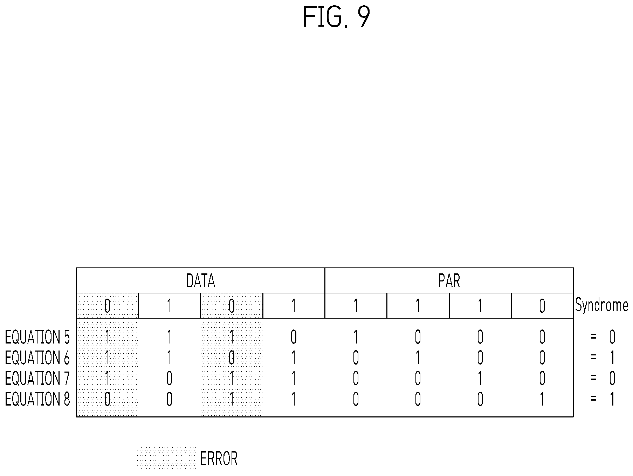

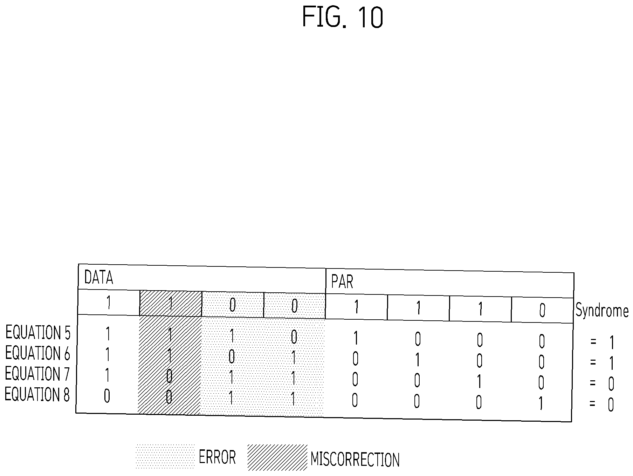

FIGS. 9 and 10 are diagrams for describing how the syndromes S0 to S3 are generated by each of the ECC decoder circuits 113, 151, 213, and 353 and how a 2-bit error is processed when the 2-bit error exists in the data DATA input to the ECC decoder circuits 113, 151, 213, and 353 in FIGS. 1 to 3 in accordance with an embodiment of the present disclosure.

Referring to FIG. 9, it can be seen that an error exists in which 2 bits D0 and D2 of the data DATA are changed from 1 to 0. When the data D0 to D3 and the parity codes P0 to P3 are put into Equation 5 to Equation 8 above and are calculated, the syndromes S0 to S3 are generated as (0, 1, 0, 1). Accordingly, it can be seen that the syndromes S0 to S3 are generated with the same value as the sum of the column vectors of the bits D0 and D2 in which the error exists. That is, it can be seen that the sum of (1, 1, 1, 0) being the column vector of the bit D0 and (1, 0, 1, 1) being the column vector of the bit D2 and the values (0, 1, 0, 1) of the syndromes S0 to S3 are the same.

When the values of the syndromes S0 to S3 are not (0, 0, 0, 0), it means that an error exists. However, in the H matrix, there is no column vector with the same value as (0, 1, 0, 1) being the values of the syndromes S0 to S3, which means that an error exists but is not correctable. That is, in the case of FIG. 9, an error is detectable but is not correctable.

Referring to FIG. 10, it can be seen that an error exists in which 2 bits D2 and D3 of the data DATA are changed from 1 to 0. In this case, the syndromes S0 to S3 are generated as (1, 1, 0, 0) being the sum of the column vector (1, 0, 1, 1) of the bit D2 and the column vector (0, 1, 1, 1) of the bit D3.

When the values of the syndromes S0 to S3 are not (0, 0, 0, 0), it means that an error exists. In the H matrix, because the column vector (1, 1, 0, 0) of the bit D1 exists as a column vector having the same value as (1, 1, 0, 0) being the values of the syndromes S0 to S3, the ECC decoder circuits 113, 151, 213, and 353 determine that an error exists in the bit D1 and correct the error by inverting the bit D1. Portions where an error has actually occurred are the bits D2 and D3, but the error in the bits D2 and D3 remains, and the bit D1 having no error is corrected, which causes miscorrection in which an error increases.

The reason why the miscorrection illustrated in FIG. 10 occurs is because errors are not distinguishable by only the values of the syndromes S0 to S3. For example, as illustrated in FIG. 10, when an error occurs in the bits D2 and D3 and when an error occurs in the bit D1, because the values of the syndromes S0 to S3 are generated the same, the ECC decoder circuits 113, 151, 213, and 353 determine that an error has occurred in the bit D1 and make miscorrection. Hereinafter, the configuration of the H matrix for preventing such miscorrection is described.

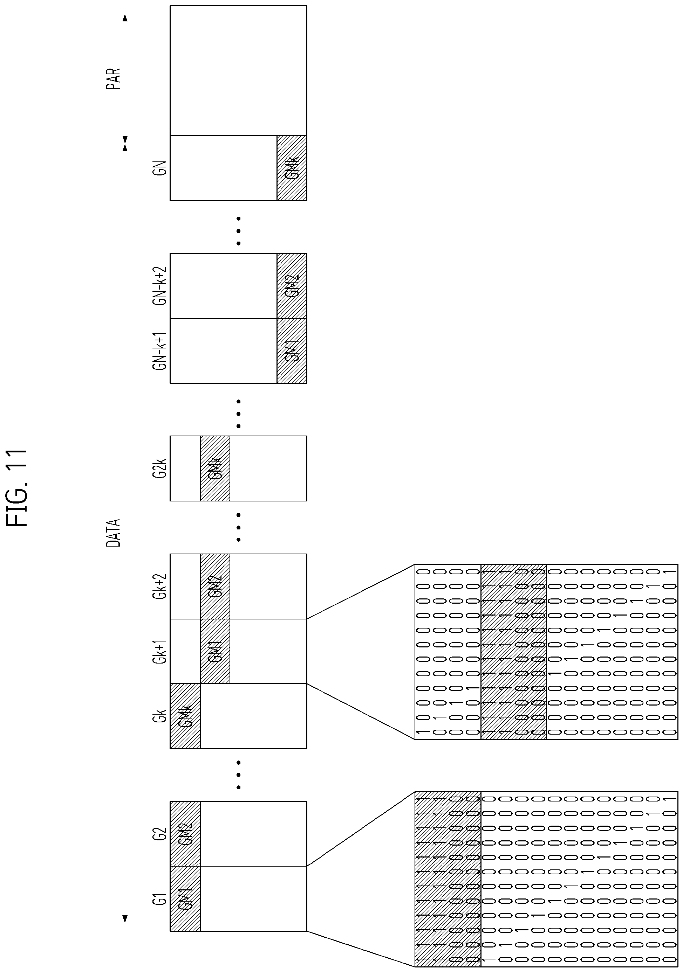

FIG. 11 is a diagram illustrating the configuration of the H matrix for preventing miscorrection and correctly detecting an error in accordance with an embodiment of the present disclosure.

Referring to FIG. 11, a data portion DATA of the H matrix is divided into N groups G1 to GN. Each of the groups G1 to GN may include, for example, a group matrix portion for distinguishing the groups and a non-group matrix portion for distinguishing bits within the group. In an embodiment, in the groups G1 to GN of FIG. 11, a colored portion corresponds to the group matrix portion, and an uncolored portion corresponds to the non-group matrix portion.

In an embodiment, in the N groups G1 to GN, the group matrix portion is used by k group matrices GM1 to GMk that circulate. Each time the k group matrices GM1 to GMk circulate one round, insertion positions of the group matrices GM1 to GMk in the groups G1 to GN are changed (i.e., shifted). For example, it can be seen that in the groups G1 to G7, the group matrices GM1 to GMk are inserted into upper rows, but in the groups Gk+1 to G2k, the group matrices GM1 to GMk are inserted into rows lower than in the groups G1 to G7. It can also be seen that in the groups GN-k+1 to GN, the group matrices GM1 to GMk are inserted into the lowest rows. In each of the group matrices GM1 to GMk, all column vectors within the same group have the same form. FIG. 11 illustrates an example 1101 of the group G1 and an example 1103 of the group Gk+1. It can be seen that the group matrix of the group G1 has a form in which column vectors of all columns are (1, 1, 0, 0) and the group matrix of the group Gk+1 also has a form in which column vectors of all columns are also (1, 1, 0, 0). However, it can be seen that in the group G1, the group matrices are inserted into the uppermost four rows, but in the group Gk+1, the group matrices are inserted into fifth to eighth rows. That is, it can be seen that the group matrix GM1 inserted into the group G1 and the group matrix GM1 inserted into the group Gk+1 are the same as each other, but the insertion positions thereof are different from each other.

In an embodiment, the non-group matrix portion of the groups G1 to GN has a form in which the weights of column vectors of all columns (the number of 1s in a column) are 1, like an identity matrix. Referring to the example 1103 of the group G1 and the example 1103 of the group Gk+1 in FIG. 11, it can be seen that the non-group matrix of the group G1 has a form in which the weights of column vectors of all columns are 1 and the non-group matrix of the group Gk+1 also has a form in which the weights of column vectors of all columns are 1.

In an embodiment, the parity code portion PAR of the H matrix has a form in which the weights of column vectors of all columns are 1, like the unit matrix.

When the H matrix is configured to comply with the rules described above, all column vectors in the data portion DATA and the parity code portion PAR of the H matrix are linearly independent. Accordingly, when the ECC circuits 111, 113, 151, 153, 211, 213, 351, and 353 use such an H matrix, the ECC decoder circuits 113, 151, 213, and 353 have SEC capability that is capable of correcting any 1-bit error. The ECC decoder circuits 113, 151, 213, and 353 can detect consecutive multi-bit errors without causing miscorrection.

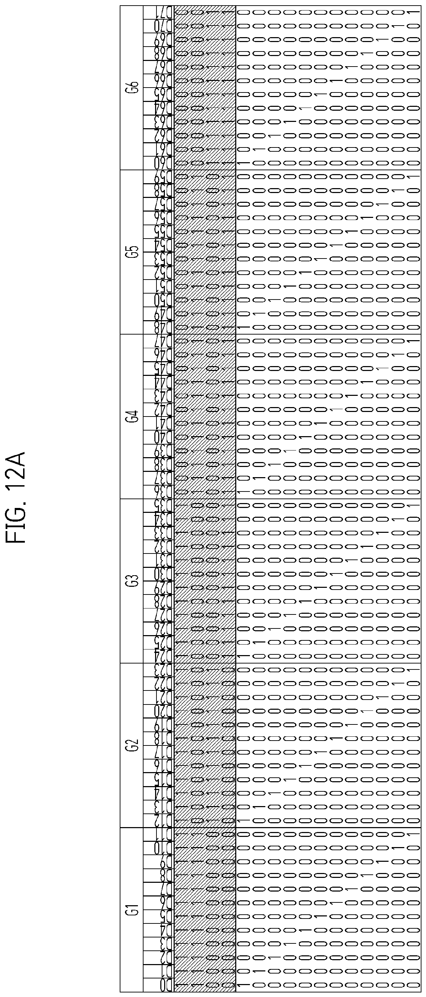

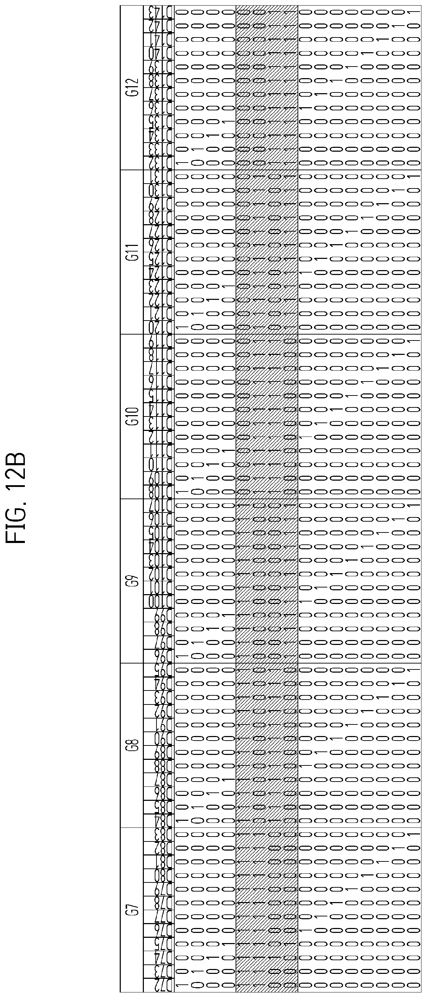

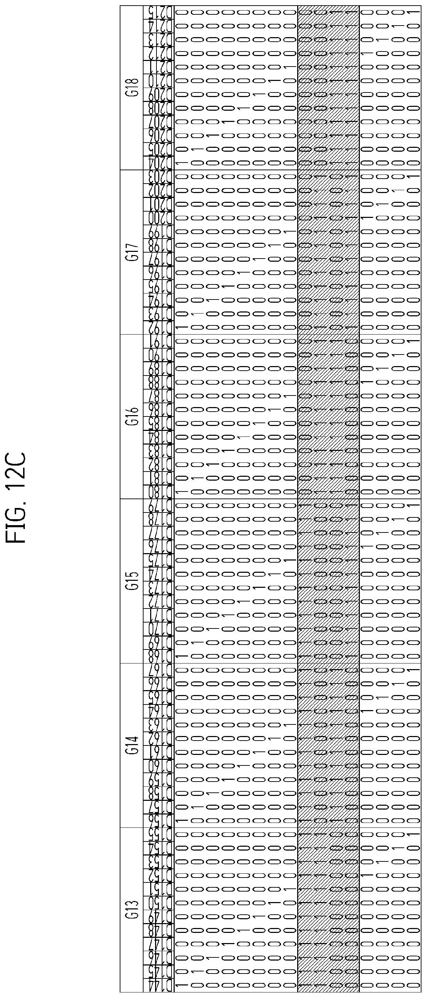

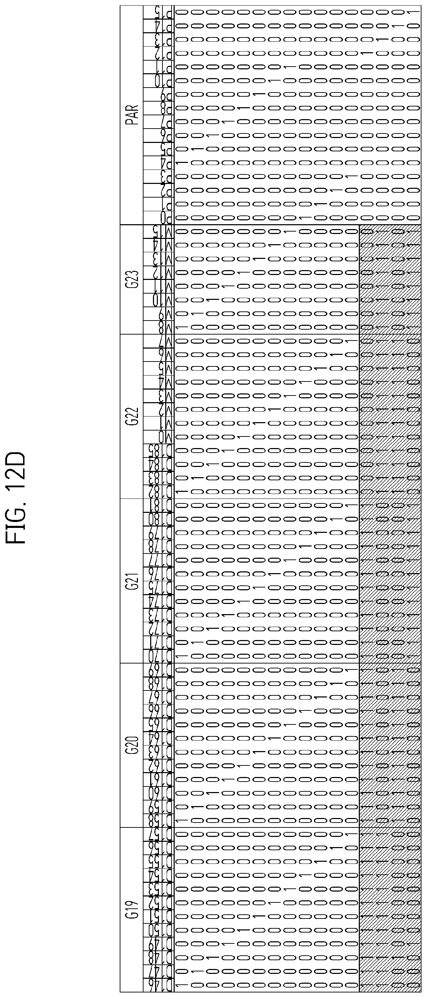

FIGS. 12A to 12D are diagrams for describing an H matrix that complies with the rules described above in accordance with embodiments of the present disclosure.

FIGS. 12A to 12D illustrate an example in which the number of bits of data DATA is 272 bits [256 bits of normal data D0 to D255 + 16 bits of meta data M0 to M15], and the parity bit PAR is 16 bits P0 to P15. Therefore, the H matrix has a size of 16 × 288. In addition, FIGS. 12A to 12D illustrate an example in which the data (D0 to D255 and M0 to M15) portion of the H matrix is divided into 23 groups G1 to G23 each with a size of 12 bits. Because the total number of bits of data D0 to D255 and M0 to M15 is 272 bits, the size of the last group G23 is 8 bits instead of 12 bits.

Referring to FIGS. 12A to 12D, it can be seen that six group matrices with column vector values of (1, 1, 0, 0), (1, 0, 1, 0), (1, 0, 0, 1), (0, 1, 1, 0), (0, 1, 0, 1), and (0, 0, 1, 1) are used repeatedly and each time one round is repeated, the insertion positions of the group matrices in the groups G1 to G23 are changed. For example, it can be seen that in the group G3, a group matrix with the column vector value of (1, 0, 0, 1) is inserted into first to fourth rows and in the group G9, a group matrix with the column vector value of (1, 0, 0, 1) is inserted into fifth to eighth rows.

Referring to FIGS. 12A to 12D, it can be seen that non-group matrices of the groups G1 to G23 each have a form in which the weights of column vectors of all columns are 1. Likewise, it can be seen that the parity code PAR portion of the H matrix also has a form in which the weights of column vectors of all columns are 1.

When the H matrix as illustrated in FIGS. 12A to 12D is used, any bit among the 272 bits of data can be corrected when a 1-bit error occurs. This may be possible because all bits of the H matrix are linearly independent.

All errors occurring in data of any consecutive 12 bits (maximum size of groups) can be detected without miscorrection. For example, even though an error of 1 to 12 bits occurs in the data D0 to D11, the error can be detected. Even though an error of 1 to 12 bits occurs in the data D5 to D16, the error can be detected. Even though an error of 1 to 12 bits occurs in the data D78 to D89, the error can be detected.

When the consecutive 12-bit data D0 to D11 are all errors, syndromes S0 to S15 are generated as a value obtained by adding up all the column vectors of the data D0 to D11 of the H matrix. This value is (0, 0, 0, 0, 1, 1, 1, 1, 1, 1, 1, 1, 1, 1, 1, 1), and because no column vector identical to this exists in the H matrix, no miscorrection occurs. Because the values of the syndromes S0 to S15 are not all 0, it can be seen that an error exists, that is, the error can be detected.

When three bits D5, D13, and D15 are errors in consecutive 12-bit data D5 to D16, the syndromes S0 to S15 are generated by adding up all the column vectors (1, 1, 0, 0, 0, 0, 0, 0, 0, 1, 0, 0, 0, 0, 0, 0), (1, 0, 1, 0, 0, 1, 0, 0 , 0, 0, 0, 0, 0, 0, 0, 0), and (1, 0, 1, 0, 0, 0, 0, 1, 0, 0, 0, 0, 0, 0, 0, 0) of the data D5, D13, and D15 of the H matrix. This value is (1, 1, 0, 0, 0, 1, 0, 1, 0, 1, 0, 0, 0, 0, 0, 0), and because no column vector identical to this exists in the H matrix, no miscorrection occurs. Because the values of the syndromes S0 to S15 are not all 0, it can be seen that an error exists, that is, the error can be detected.

No matter which case is calculated, it can be seen that an error can be detected without miscorrection no matter how many errors occur in any consecutive 12-bit data.

The data is divided into normal data D0 to D255 and meta data M0 to M15, this is merely a difference in the purpose of the data, and in the H matrix and ECC circuits 111, 113, 151, 153, 211, 213, 351, and 353, the normal data D0 to D255 and the meta data M0 to M15 are treated the same.

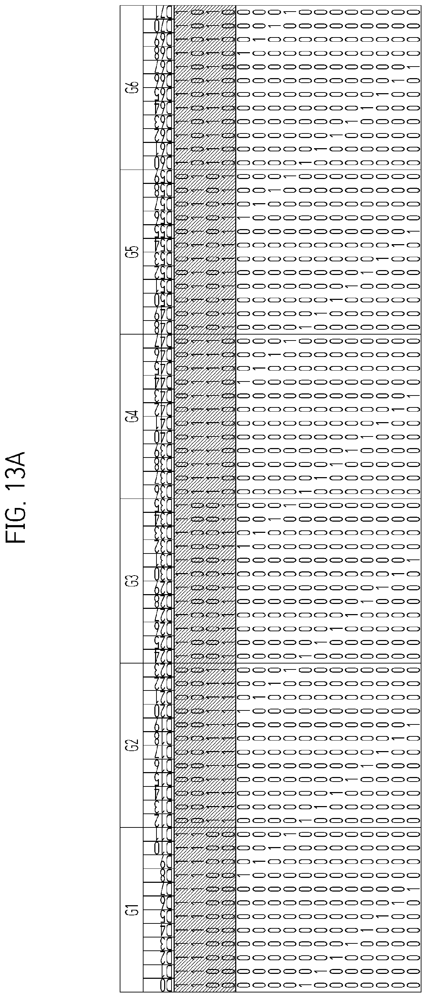

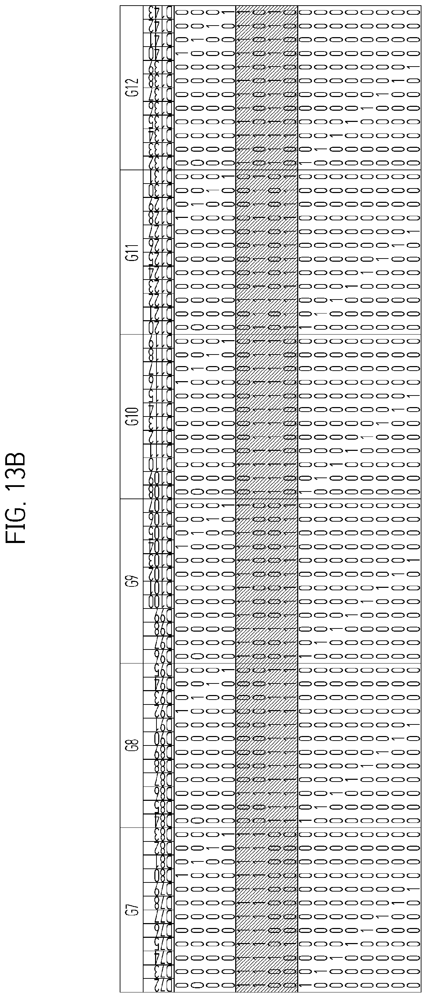

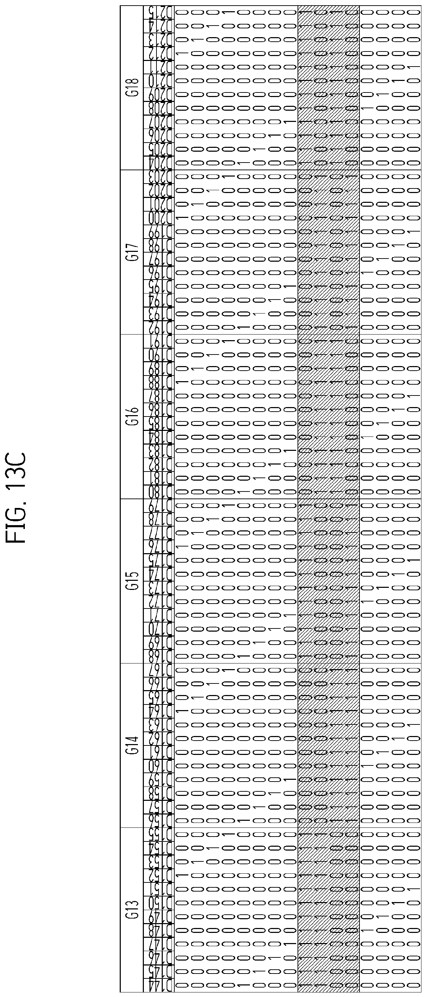

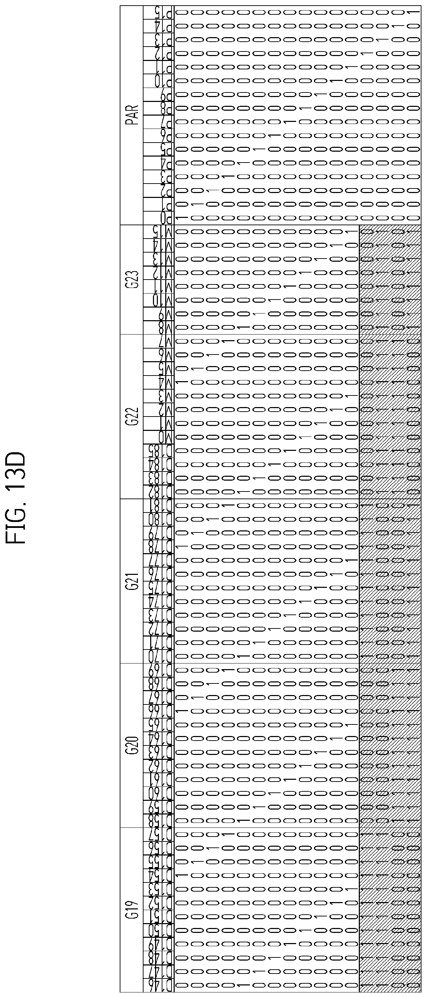

FIGS. 13A to 13D are diagrams for describing another H matrix that complies with the rules described above in accordance with an embodiment of the present disclosure.

Likewise the case of FIGS. 12A to 12D, FIGS. 13A to 13D illustrate an example in which the number of bits of data DATA is 272 bits [256 bits of normal data D0 to D255 + 16 bits of meta data M0 to M15], and the parity bit PAR is 16 bits P0 to P15. Therefore, the H matrix has a size of 16 × 288. In addition, FIGS. 13A to 13D illustrate an example in which the data (D0 to D255 and M0 to M15) portion of the H matrix is divided into 23 groups G1 to G23 each with a size of 12 bits. Because the total number of bits of data D0 to D255 and M0 to M15 is 272 bits, the size of the last group G23 is 8 bits instead of 12 bits.

Referring to FIGS. 13A to 13D, it can be seen that six group matrices with column vector values of (1, 1, 0, 0), (0, 0, 1, 1), (1, 0, 0, 1), (0, 1, 1, 0), (0, 1, 0, 1), (1, 0, 1, 0) are used repeatedly and each time one round is repeated, the insertion positions of the group matrices in the groups G1 to G23 are changed. For example, it can be seen that in the group G4, a group matrix with the column vector value of (0, 1, 1, 0) is inserted into first to fourth rows and in the group G10, a group matrix with the column vector value of (0, 1, 1, 0) is inserted into fifth to eighth rows.

Referring to FIGS. 13A to 13D, it can be seen that non-group matrices of the groups G1 to G23 each have a form in which the weights of column vectors of all columns are 1. Likewise, it can be seen that the parity code PAR portion of the H matrix also has a form in which the weights of column vectors of all columns are 1.

When the H matrix as illustrated in FIGS. 13A to 13D is used, any bit among the 272 bits of data can be corrected when a 1-bit error occurs. This may be possible because all bits of the H matrix are linearly independent.

All errors occurring in data of any consecutive 12 bits (maximum size of groups) can be detected without miscorrection. For example, even though an error of 1 to 12 bits occurs in the data D0 to D11, the error can be detected. Even though an error of 1 to 12 bits occurs in the data D5 to D16, the error can be detected. Even though an error of 1 to 12 bits occurs in the data D78 to D89, the error can be detected.

Assuming that the consecutive 12-bit data D12 to D23 are all errors, syndromes S0 to S15 are generated as a value obtained by adding up all the column vectors of the data D12 to D23 of the H matrix. This value is (0, 0, 0, 0, 1, 1, 1, 1, 1, 1, 1, 1, 1, 1, 1, 1), and because no column vector identical to this exists in the H matrix, no miscorrection occurs. Because the values of the syndromes S0 to S15 are not all 0, it can be seen that an error exists (the error can be detected).

When four bits D47, D48, D57, and D58 are errors in consecutive 12-bit data D47 to D58, the syndromes S0 to S15 are generated by adding up all column vectors (0, 1, 1, 0, 0, 0, 0, 1, 0, 0, 0, 0, 0, 0, 0, 0), (0, 1, 0, 1, 0, 0, 0, 0 , 1, 0, 0, 0, 0, 0, 0, 0), (0, 1, 0, 1, 0, 1, 0, 0, 0, 0, 0, 0, 0, 0, 0, 0), (0, 1, 0, 1, 0, 0, 1, 0, 0, 0, 0, 0, 0, 0, 0, 0) of the data D47, D48, D57, and D58 of the H matrix. This value is (0, 1, 0, 1, 0, 1, 1, 1, 0, 0, 0, 0, 0, 0, 0, 0), and because no column vector identical to this exists in the H matrix, no miscorrection occurs. Because the values of the syndromes S0 to S15 are not all 0, it can be seen that an error exists (the error can be detected).

No matter which case is calculated, it can be seen that an error can be detected without miscorrection no matter how many errors occur in any consecutive 12-bit data.

When the ECC circuits 111, 113, 151, 153, 211, 213, 351, and 353 of FIGS. 1 to 3 use one of the H matrices proposed in FIGS. 11 to 13, a random 1-bit error can be corrected, and miscorrection can be prevented while detecting many errors.

Although embodiments according to the technical idea of the present disclosure have been described above with reference to the accompanying drawings, this is only for describing the embodiments according to the concept of the present disclosure, and the present disclosure is not limited to the above embodiments. Various types of substitutions, modifications, and changes for the embodiments may be made by those skilled in the art, to which the present disclosure pertains, without departing from the technical idea of the present disclosure defined in the following claims, and it should be construed that these substitutions, modifications, and changes belong to the scope of the present disclosure. Furthermore, the embodiments may be combined to form additional embodiments.

## Claims

1. An integrated circuit comprising:
an ECC encoder circuit configured to operate an H matrix on transmission data, to generate a transmission parity to be transmitted together with the transmission data, the transmission parity corresponding to the transmission data; and
an ECC decoder circuit configured to operate the H matrix on reception data and a reception parity to detect and correct an error in the reception data,
wherein a data portion of the H matrix is divided into N groups,
each of the N groups comprises a group matrix portion for distinguishing groups and a non-group matrix portion for distinguishing bits within a corresponding group,
the group matrix portion is used by k group matrices that circulate in the N groups, and each time the k group matrices circulate one round, positions of the k group matrices inserted in groups are shifted, where k is an integer equal to or more than 2 and N is an integer greater than k.

2. The integrated circuit of claim 1, wherein the non-group matrix portion of each of the N groups has a form in which weights of all column vectors are 1.

3. The integrated circuit of claim 2, wherein in the group matrix portion of each of the N groups, all column vectors within a same group have a same form.

4. The integrated circuit of claim 3, wherein a parity code portion of the H matrix has a form in which weights of all column vectors are 1.

5. The integrated circuit of claim 4, wherein all column vectors of the H matrix are linearly independent.

6. The integrated circuit of claim 5, wherein the ECC decoder circuit is able to correct a 1-bit error in the reception data.

7. The integrated circuit of claim 5, wherein the ECC decoder circuit is able to detect up to X errors within consecutive X bits of the reception data, where X is a maximum column size of the N groups.

8. The integrated circuit of claim 1, wherein the shift in the positions of the k group matrices indicates a shift of a row where the k group matrices are inserted.

9. The integrated circuit of claim 1, wherein each of the transmission data and the reception data comprises normal data and meta data.

10. The integrated circuit of claim 1, wherein, when the integrated circuit is a memory controller,
the transmission data is write data to be written to a memory, the reception data is read data read from the memory, and the memory controller further comprises:
a data transmission circuit configured to transmit the transmission data and the transmission parity to the memory; and
a data reception circuit configured to receive the read data and the reception parity transmitted from the memory.

11. The integrated circuit of claim 1, wherein, when the integrated circuit is a memory,
the reception data is write data and the reception parity is a write parity,
the transmission data is read data and the transmission parity is a read parity, and
the memory further comprises:
a data reception circuit configured to receive the write data and the write parity transmitted from a memory controller;
a memory core configured to store write data processed by the ECC decoder circuit and provide the stored data to the ECC encoder circuit as the read data; and
a data transmission circuit configured to transmit the read data and the read parity to the memory controller.

12. A memory system comprising a memory controller and a memory, wherein the memory controller comprises:
a first ECC encoder circuit configured to operate an H matrix on write data to generate a write parity corresponding to the write data;
a first data transmission circuit configured to transmit the write data and the write parity to the memory;
a first data reception circuit configured to receive read data and a read parity transmitted from the memory; and
a first ECC decoder circuit configured to operate the H matrix on the read data and the read parity to detect and correct an error in the read data,
wherein a data portion of the H matrix is divided into N groups,
each of the N groups comprises a group matrix portion for distinguishing groups and a non-group matrix portion for distinguishing bits within a corresponding group,
the group matrix portion is used by k group matrices that circulate in the N groups, and each time the k group matrices circulate one round, positions of the k group matrices inserted in groups are shifted, where k is an integer equal to or more than 2 and N is an integer greater than k.

13. The memory system of claim 12, wherein the memory comprises:
a second data reception circuit configured to receive the write data and the write parity transmitted from the memory controller;
a second ECC decoder circuit configured to operate the H matrix on the write data and the write parity received through the second data reception circuit to detect and correct an error in the write data,
a memory core configured to store the write data processed by the second ECC decoder circuit, and provide the stored data as the read data;
a second ECC encoder circuit configured to operate the H matrix on the read data to generate a read parity; and
a second data transmission circuit configured to transmit the read data and the read parity to the memory controller.

14. The memory system of claim 13, wherein the non-group matrix portion of each of the N groups has a form in which weights of all column vectors are 1.

15. The memory system of claim 14, wherein in the group matrix portion of each of the N groups, all column vectors within a same group have a same form.

16. The memory system of claim 15, wherein a parity code portion of the H matrix has a form in which weights of all column vectors are 1.

17. The memory system of claim 16, wherein all column vectors of the H matrix are linearly independent.

18. The memory system of claim 17, wherein each of the first ECC decoder circuit and the second ECC decoder circuit is able to correct a 1-bit error in data processed by each of the first ECC decoder circuit and the second ECC decoder circuit.

19. The memory system of claim 17, wherein each of the first ECC decoder circuit and the second ECC decoder circuit is able to detect up to X errors within consecutive X bits of data processed by each of the first ECC decoder circuit and the second ECC decoder circuit, where X is a maximum column size of the N groups.

20. The memory system of claim 12, wherein the shift in the positions of the k group matrices indicates a shift of a row where the k group matrices are inserted.

21. The memory system of claim 12, wherein each of the write data and the read data comprises normal data and meta data.
